# EUROPÄISCHE PATENTSCHRIFT

(11) **EP 2 127 505 B1**
(45) Veröffentlichungstag und Bekanntmachung des Hinweises auf die Patenterteilung: **20.10.2010**
(21) Anmeldenummer: 07847108.3
(22) Anmeldetag: 02.11.2007
(51) Int. Cl.: H05K 1/16

(54) **VERFAHREN ZUR HERSTELLUNG EINES ELEKTRISCHEN WIDERSTANDS AUF EINEM SUBSTRAT**
METHOD FOR PRODUCING AN ELECTRICAL RESISTOR ON A SUBSTRATE
PROCÉDÉ DE FABRICATION D'UNE RÉSISTANCE ÉLECTRIQUE SUR UN SUBSTRAT

(30) Priorität: 21.12.2006 DE 102006060634
(43) Veröffentlichungstag der Anmeldung: 02.12.2009
(73) Patentinhaber: Robert Bosch GmbH, 70442 Stuttgart (DE)
(72) Erfinder: ROETHLINGSHOEFER, Walter, 72766 Reutlingen (DE)
(86) Internationale Anmeldenummer: PCT/EP2007/061831
(87) Internationale Veröffentlichungsnummer: WO 2008/077671

(56) Entgegenhaltungen:
- US-A- 4 464 420
- US-A- 5 221 644
- US-A- 5 345 212
- US-A- 5 966 067
- US-A1- 2005 205 195

## Beschreibung

Die Erfindung betrifft ein Verfahren zur Herstellung eines elektrischen Widerstands, insbesondere Stromfühlerwiderstands, auf einem Substrat, wobei ein Widerstandsrohling auf das Substrat aufgebracht und anschließend zur Bildung des Widerstands temperaturbehandelt wird.

### Stand der Technik

Es ist bekannt, elektrische Widerstände, insbesondere Stromfühlerwiderstände, auf Substraten herzustellen. Dies erfolgt insbesondere in Dickschichttechnik und LTCC-Technik (LTCC = low temperature cofire ceramic). Hierzu werden SilberpalladiumPasten im Siebdruckverfahren auf das Substrat aufgedruckt. Die Integration solcher insbesondere als Leiterbahnwiderstände ausgebildeten Widerstände mit typischen Widerstandswerten von zum Beispiel 100 mOhm und Temperaturkoeffizient-Werten von zum Beispiel 100 ppm/K erfordern hohe Prozessaufwendungen, wie zum Beispiel das Anschließen dieses Widerstandes mit hochsilberhaltigen, niederohmigen Leiterbahnen, gleichzeitig ist das Anbringen von Zwischenlegierungen (intermediates) erforderlich, was zusätzliche Aufdruckschritte und Temperaturbehandlungsschritte erfordert. Derartige Zusatzschritte sind oftmals aufgrund der Auslegung der Fertigungslinien gar nicht möglich. Die aufgedruckten Silberpalladiumpasten, die einen vorgemischten Widerstand darstellen, werden zur Fertigstellung des Widerstandes gebrannt, also temperaturbehandelt. US 5345212 A beschreibt ein Verfahren zur Ausbildung eines Widerstands auf einem Substrat. Hierzu wird eine Silber-Palladium-Paste verwendet, die in einem ersten Verfahrensschritt auf das Substrat gedruckt wird. In einem anschließenden Brennprozess werden noch in der Silber-Palladium-Paste enthaltene organische Bestandteile ausgebrannt und der Widerstand auf dem Substrat ausgebildet Optional kann der gebildete Widerstand mit einer Schutzschicht, beispielsweise einem Silikatglass, überzogen werden.

### Offenbarung der Erfindung

Aufgrund des erfindungsgemäßen Verfahrens zur Herstellung eines elektrischen Widerstands, insbesondere Stromfühlerwiderstands, auf einem Substrat wird ein Widerstandsrohling auf das Substrat aufgebracht und anschließend zur Bildung des Widerstands temperaturbehandelt, wobei zur Bildung des Widerstandsrohlings eine Palladiumschicht auf das Substrat aufgebracht und anschließend auf die Palladiumschicht eine Silberschicht aufgebracht wird. Alternativ wird eine Silberschicht auf das Substrat und auf die Silberschicht eine Palladiumschicht aufgebracht. Danach erfolgt eine Temperaturbehandlung, sodass das Palladium der Palladiumschicht mit dem Silber der Silberschicht durchlegiert. Diese Legierung stellt dann den gewünschten Widerstand, insbesondere Stromfühlerwiderstand, dar. Die Herstellung dieses Widerstands erfolgt in einem so genannten cofire-Prozess, das heißt, in situ, also am Ort und während des Brennschrittes wird aus dem Widerstandsrohling der elektrische Widerstand gebildet. Damit besteht gegenüber dem bisherigen Verfahren ein entscheidender Unterschied, da sich aufgrund der Temperaturbehandlung eine den Widerstand bildende Legierung bildet, und zwar aufgrund der Durchlegierung getrennter Schichten, während im Stand der Technik vor dem Brennprozess fertig gestellte Silberpalladiumpaste verwendet wird, die nach dem insbesondere per Siebdruck erfolgenden Aufbringen gebrannt wird. Die Einstellung der Parameter des Widerstandes erfolgt durch eine entsprechend gewählte Menge an Palladium relativ zur Silbermenge. Auf diese Art und Weise lässt sich sowohl der Widerstandswert als auch der Temperaturkoeffizient (TK-Wert) in gewünschter Weise einstellen. Bei dem Temperaturkoeffizienten handelt es sich um eine Angabe, um wie viel Ohm sich jedes Ohm des Widerstandes pro °K ändert. Aufgrund des erfindungsgemäßen Vorgehens treten keine Diffusionszonen, insbesondere beim Kontaktieren von angrenzenden Anschlusszonen, auf und es ist ferner sichergestellt, dass sich keine Kirkendall-Hohlräume (Kirkendall-Voids) bilden. Derartige Diffusionszonen mit Voidbildungen führen zu Zuverlässigkeitsproblemen aufgrund von Driften oder gar Leiterbahnabrissen. Von besonderer Bedeutung ist, dass das Palladium separat aufgebracht und - zusammen mit dem Silber - der Widerstandswert durch Legierungsbildung im cofire-Prozess eingestellt wird. Im Gegensatz dazu wird üblicherweise eine fertig gemischte Silberpalladiumpaste verwendet, die mit Zusatzschritten, wie Drucken und Brennen, aufgebracht wird und über zusätzlich aufgebrachte Zwischenlegierungen an den Anschlusszonen kontaktiert werden.

Nach einer Weiterbildung der Erfindung ist vorgesehen, dass das Aufbringen der Palladiumschicht und/oder der Silberschicht im Druckverfahren erfolgt. Insbesondere wird das Druckverfahren als Siebdruckverfahren durchgeführt. Mithin wird im Siebdruckverfahren zunächst die Palladiumschicht und darauf die Silberschicht aufgebracht.

Ferner ist es vorteilhaft, wenn die Silberschicht die Palladiumschicht zur Ausbildung von elektrischen Anschlusszonen seitlich überragt. Mithin bildet sich die Legierung nur im Überlappungsbereich von Silber und Palladium und die überragenden Silberschichtabschnitte können zur Ausbildung von elektrischen Anschlusszonen genutzt werden, die vorzugsweise mit Silber-Durchkontaktierungen des Substrats verbunden werden.

Ferner ist von Vorteil, wenn auf den Widerstandsrohling eine Abdeckglasschicht aufgebracht wird. Diese wird vorzugsweise aufgedruckt, insbesondere per Siebdruck, wobei die Abdeckglasschicht vor der Temperaturbehandlung aufgebracht wird. Es handelt sich dabei also zunächst um noch nicht gebranntes Glas, das durch die Temperaturbehandlung dann gebrannt wird. Die Abdeckglasschicht schützt den elektrischen Widerstand.

Nach einer Weiterbildung der Erfindung ist vorgesehen, dass die Palladiumschicht unter zumindest bereichsweise erfolgender Zwischenschaltung eines Haftvermittlers auf das Substrat aufgebracht wird. In einem solchen Falle befindet sich also die Palladiumschicht auf dem Substrat, das heißt, nicht unmittelbar, sondern unter Zwischenschaltung des Haftvermittlers, sodass die Palladiumschicht sicher auf dem Substrat gehalten wird. Anschließend wird die Palladiumschicht dann mit der Silberschicht versehen.

Es ist vorteilhaft, wenn die Schichten als Leiterbahnschichten ausgebildet werden. Demzufolge handelt es sich um Strukturen, die leiterbahnähnlich ausgebildet sind, das heißt ein Leiterbahnabschnitt bildet den erwähnten elektrischen Widerstand, insbesondere Stromfühlerwiderstand. Auch die Abdeckglasschicht kann leiterbahnähnlich ausgebildet sein, was nicht bedeutet, dass eine elektrische Leitfähigkeit bei der Abdeckglasschicht vorliegt, sondern dass die Abdeckglasschicht die Formgebung einer Leiterbahn besitzt.

Es ist ferner vorteilhaft, wenn der Haftvermittler ebenfalls durch einen Druckprozess, insbesondere durch einen Siebdruckprozess, aufgebracht wird.

Ferner ist es vorteilhaft, wenn das Verfahren in Dickschichttechnik erfolgt.

Als Substrat kann insbesondere ein Keramiksubstrat verwendet werden, wobei es sich insbesondere um LTCC-Keramik handeln kann, also um low temperature cofired ceramic. Das Keramiksubstrat kann mittels mehrerer, aufeinander geschichteter Keramikfolien ausgebildet werden. Zwischen den Keramikfolien befinden sich vorzugsweise Leiterbahnschichten, sodass eine mehrlagige Leiterbahnstruktur entsteht.

Nach einer Weiterbildung der Erfindung ist vorgesehen, dass die elektrischen Anschlusszonen als Durchkontaktierungen, insbesondere Silberdurchkontaktierungen (Silber-Via) ausgebildet werden.

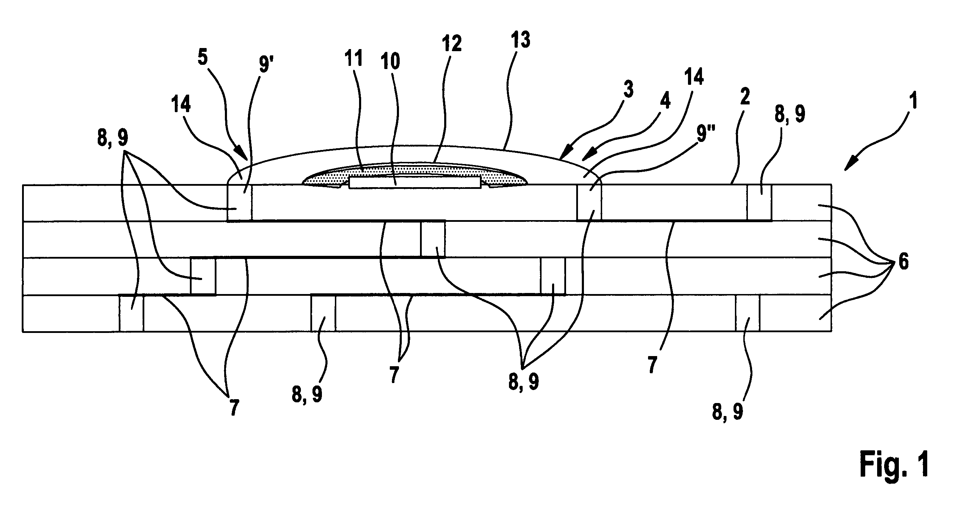

### Kurze Beschreibung der Zeichnung

Die Zeichnung veranschaulicht die Erfindung anhand eines Ausführungsbeispiels, und zwar zeigt die Figur einen Querschnitt durch ein mit elektrischen Widerstand, insbesondere Stromfühlerwiderstand, versehenes Substrat.

### Ausführungsform der Erfindung

Die Figur zeigt ein Substrat 1 aus elektrisch isolierendem Material, auf dessen Oberseite 2 ein elektrischer Widerstand 3, insbesondere ein Stromfühlerwiderstand 4, angeordnet ist. In der Figur ist der Widerstand 3 noch als Widerstandsrohling 5 gezeigt, der durch einen Verarbeitungsschritt - wie nachstehend angeführt - in den Widerstand 3 überführt wird. Der Begriff "Stromfühlerwiderstand" bedeutet, dass mittels dieses Widerstandes ein Stromfluss erfasst wird, sodass eine Aussage über das Fließen dieses Stromes getroffen werden kann.

Das Substrat 1 ist mehrlagig ausgebildet, das heißt, es weist mehrere Schichten 6 auf, zwischen denen Leiterbahnen 7 angeordnet sind. Die Leiterbahnen 7 können mittels Durchkontaktierungen 8 miteinander elektrisch verbunden sein. Die Durchkontaktierungen 8 sind vorzugsweise als Silberdurchkontaktierungen 9 ausgebildet. Das Substrat 1 ist vorzugsweise als Keramiksubstrat ausgebildet, wobei die einzelnen Schichten 6 von Keramikfolien gebildet sind.

Um zwischen den Silberkontaktierungen 9' und 9" den Widerstand 3 auszubilden, wird zunächst auf die Oberseite 2 des Substrats ein Haftvermittler 10, insbesondere ein Palladium-Haftvermittler 11, aufgebracht. Das Aufbringen erfolgt vorzugsweise mittels Siebdruckverfahren. Über den Haftvermittler 10 wird dann eine Palladiumschicht 12 in Form einer Leiterbahn aufgebracht, insbesondere aufgedruckt, vorzugsweise mittels Siebdruckverfahren. Der Palladium-Haftvermittler 11 sorgt dafür, dass die Palladiumschicht 12 hinreichend fest mit der Oberseite 2 des Substrats 2 verbunden ist. Anschließend wird über die Palladiumschicht 12 eine Silberschicht 13 aufgebracht, insbesondere aufgedruckt, vorzugsweise nach dem Siebdruckverfahren. Dabei wird ebenfalls eine Struktur entsprechend einer Leiterbahn erzeugt, derart, dass die beiden Silberdurchkontaktierungen 9' und 9" miteinander verbunden werden. Die Palladiumschicht 12 ist kürzer als die Silberschicht 13, das heißt, die Silberschicht 13 überragt seitlich die Palladiumschicht, um zu den Silberdurchkontaktierungen 9' und 9" elektrische Anschlusszonen 14 auszubilden.

Nach den vorstehend erwähnten Arbeitsschritten wird mittels eines Einbrennprozesses, also in einem gemeinsamen Brennschritt, zusammen mit dem als Mehrlagenkeramik ausgebildeten Substrat der Widerstand 3 eingebrannt, das heißt, das Palladium der Palladiumschicht 12 wird mit dem Silber der Silberschicht 13 durchlegiert. Je nach gewählter Palladiummenge werden die gewünschten Zielwerte im Hinblick auf den spezifischen Widerstand und/oder den Temperaturkoeffizienten des Widerstands 3 eingestellt.

Zusätzlich ist es möglich, dass vor dem Brennschritt über die Silberschicht 13 eine Abdeckglasschicht aufgebracht wird, die - nach dem Brennschritt - eine Schutzschicht für den Widerstand 3 bildet.

Wie sich aus dem Vorstehenden ergibt, wird durch das separate Anbringen von Palladium und Silber eine Einstellung des Widerstandswerts entsprechend der gewählten Mengen vorbereitet und durch die anschließende Legierungsbildung im cofire-Prozess der Widerstand 3, insbesondere der Stromführungswiderstand 4, ausgebildet, wobei insbesondere gleichzeitig die Anschlusszonen 4 erzeugt und mit entsprechenden Gegenelementen, beispielsweise Silberdurchkontaktieren 9' und 9", elektrisch verbunden werden.

## Patentansprüche

1. Verfahren zur Herstellung eines elektrischen Widerstands, insbesondere Stromfühlwiderstands, auf einem Substrat (1), wobei ein Widerstandsrohling (5) auf das Substrat (1) aufgebracht und anschließend zur Bildung des Widerstands (3) temperaturbehandelt wird, **dadurch gekennzeichnet,**
**dass** zur Bildung des Widerstandsrohlings (5) eine Palladiumschicht (12) auf das Substrat (1) aufgebracht und dass auf die Palladiumschicht (12) eine Silberschicht (13) aufgebracht wird oder eine Silberschicht (13) auf das Substrat (1) aufgebracht und dass auf die Silberschicht (13) eine Palladiumschicht (12) aufgebracht wird und
- **dass** anschließend durch die Temperaturbehandlung das Palladium der Palladiumschicht (12) mit dem Silber der Silberschicht (13) durchlegiert wird.

2. Verfahren nach Anspruch 1, **dadurch gekennzeichnet, dass** das Aufbringen der Palladiumschicht (12) und/oder der Silberschicht (13) mittels Druckverfahren erfolgt.

3. Verfahren nach einem der vorhergehenden Ansprüche, **dadurch gekennzeichnet, dass** das Druckverfahren als Siebdruckverfahren durchgeführt wird.

4. Verfahren nach einem der vorhergehenden Ansprüche, **dadurch gekennzeichnet, dass** das Druckverfahren als Ink Jet Druck durchgeführt wird.

5. Verfahren nach einem der vorhergehenden Ansprüche, **dadurch gekennzeichnet, dass** die Silberschicht (13) die Palladiumschicht (12) zur Ausbildung von elektrischen Anschlusszonen (4) seitlich überragt.

6. Verfahren nach einem der vorhergehenden Ansprüche, **dadurch gekennzeichnet, dass** auf dem Widerstandsrohling (5) eine Abdeckglasschicht aufgebracht wird.

7. Verfahren nach einem der vorhergehenden Ansprüche, **dadurch gekennzeichnet, dass** die Abdeckglasschicht aufgedruckt wird.

8. Verfahren nach einem der vorhergehenden Ansprüche, **dadurch gekennzeichnet, dass** die Abdeckglasschicht vor der Temperaturbehandlung aufgebracht wird.

9. Verfahren nach einem der vorhergehenden Ansprüche, **dadurch gekennzeichnet, dass** die Palladiumschicht (12) unter Zwischenschaltung eines Haftvermittlers (10) auf das Substrat (1) aufgebracht wird.

10. Verfahren nach einem der vorhergehenden Ansprüche, **dadurch gekennzeichnet, dass** der Haftvermittler (10) im Druckverfahren aufgebracht wird.

11. Verfahren nach einem der vorhergehenden Ansprüche, **dadurch gekennzeichnet, dass** die Schichten (12, 13) als Leiterbahnschichten aufgebracht werden.

12. Verfahren nach einem der vorhergehenden Ansprüche, **dadurch gekennzeichnet, dass** die Herstellung in Dickschichttechnik erfolgt.

13. Verfahren nach einem der vorhergehenden Ansprüche, **dadurch gekennzelchnet, dass** als Substrat (1) ein Keramiksubstrat verwendet wird.

14. Verfahren nach einem der vorhergehenden Ansprüche, **dadurch gekennzeichnet, dass** das Keramiksubstrat (1) von Keramikfolien gebildet wird.

15. Verfahren nach einem der vorhergehenden Ansprüche, **dadurch gekennzeichnet, dass** die elektrischen Anschlusszonen (4) als Durchkontaktierungen (9', 9"), insbesondere Silberdurchkontaktierungen, ausgebildet werden.

## Claims

1. Method for producing an electrical resistor, in particular a current sensing resistor, on a substrate (1), a resistor blank (5) being applied to the substrate (1) and subsequently thermally treated to form the resistor (3), **characterized**
- **in that**, to form the resistor blank (5), a palladium layer (12) is applied to the substrate (1) and a silver layer (13) is applied to the palladium layer (12) or a silver layer (13) is applied to the substrate (1) and a palladium layer (12) is applied to the silver layer (13) and
- **in that** subsequently the palladium of the palladium layer (12) is alloyed through with the silver of the silver layer (13) by the thermal treatment.

2. Method according to Claim 1, **characterized in that** the application of the palladium layer (12) and/or of the silver layer (13) is performed by means of a printing process.

3. Method according to one of the preceding claims, **characterized in that** the printing process is carried out as a screen printing process.

4. Method according to one of the preceding claims, **characterized in that** the printing process is carried out as an inkjet print.

5. Method according to one of the preceding claims, **characterized in that** the silver layer (13) protrudes laterally beyond the palladium layer (12) to form electrical terminal zones (4).

6. Method according to one of the preceding claims, **characterized in that** a covering glass layer is applied to the resistor blank (5).

7. Method according to one of the preceding claims, **characterized in that** the covering glass layer is printed on.

8. Method according to one of the preceding claims, **characterized in that** the covering glass layer is applied before the thermal treatment.

9. Method according to one of the preceding claims, **characterized in that** the palladium layer (12) is applied to the substrate (1) with a coupling agent (10) interposed.

10. Method according to one of the preceding claims, **characterized in that** the coupling agent (10) is applied in the printing process.

11. Method according to one of the preceding claims, **characterized in that** the layers (12, 13) are applied as interconnect layers.

12. Method according to one of the preceding claims, **characterized in that** the production is performed by the thick film technique.

13. Method according to one of the preceding claims, **characterized in that** a ceramic substrate is used as the substrate (1).

14. Method according to one of the preceding claims, **characterized in that** the ceramic substrate (1) is formed by ceramic sheets.

15. Method according to one of the preceding claims, **characterized in that** the electrical terminal zones (4) are formed as plated-through holes (9', 9"), in particular silver plated-through holes.

## Revendications

1. Procédé de fabrication d'une résistance électrique, notamment d'une résistance à détecteur de courant, sur un substrat (1), une résistance verte (5) étant appliquée sur le substrat (1) puis étant soumise à un traitement thermique pour former la résistance (3), **caractérisé en ce que**
- pour former la résistance verte (5), on applique une couche de palladium (12) sur le substrat (1) et l'on applique sur la couche de palladium (12) une couche d'argent (13), ou l'on applique une couche d'argent (13) sur le substrat (1) et l'on applique sur la couche d'argent (13) une couche de palladium (12), et
- ensuite, par traitement thermique, le palladium de la couche de palladium (12) est allié à l'argent de la couche d'argent (13).

2. Procédé selon la revendication 1, **caractérisé en ce que** l'application de la couche de palladium (12) et/ou de la couche d'argent (13) a lieu au moyen d'un procédé d'impression.

3. Procédé selon l'une quelconque des revendications précédentes, **caractérisé en ce que** le procédé d'impression est mis en oeuvre en tant que procédé de sérigraphie.

4. Procédé selon l'une quelconque des revendications précédentes, **caractérisé en ce que** le procédé d'impression est mis en oeuvre en tant que procédé d'impression à jet d'encre.

5. Procédé selon l'une quelconque des revendications précédentes, **caractérisé en ce que** la couche d'argent (13) dépasse latéralement de la couche de palladium (12) pour créer des zones de raccordement électrique (4).

6. Procédé selon l'une quelconque des revendications précédentes, **caractérisé en ce que** l'on applique sur la résistance verte (5) une couche de verre de recouvrement.

7. Procédé selon l'une quelconque des revendications précédentes, **caractérisé en ce que** la couche de verre de recouvrement est imprimée.

8. Procédé selon l'une quelconque des revendications précédentes, **caractérisé en ce que** la couche de verre de recouvrement est appliquée avant le traitement thermique.

9. Procédé selon l'une quelconque des revendications précédentes, **caractérisé en ce que** la couche de palladium (12) est appliquée en interposant un promoteur d'adhésion (10) sur le substrat (1).

10. Procédé selon l'une quelconque des revendications précédentes, **caractérisé en ce que** le promoteur d'adhésion (10) est appliqué dans un procédé d'impression.

11. Procédé selon l'une quelconque des revendications précédentes, **caractérisé en ce que** les couches (12, 13) sont appliquées en tant que couches de pistes conductrices.

12. Procédé selon l'une quelconque des revendications précédentes, **caractérisé en ce que** la fabrication a lieu conformément à une technique à couches épaisses.

13. Procédé selon l'une quelconque des revendications précédentes, **caractérisé en ce que** l'on utilise comme substrat (1) un substrat en céramique.

14. Procédé selon l'une quelconque des revendications précédentes, **caractérisé en ce que** le substrat en céramique (1) est formé par des feuilles de céramique.

15. Procédé selon l'une quelconque des revendications précédentes, **caractérisé en ce que** les zones de raccordement électrique (4) sont réalisées sous forme de trous conducteurs (9', 9"), notamment de trous conducteurs en argent.
